# EUROPEAN PATENT SPECIFICATION

(11) **EP 4 584 090 B1**
(45) Date of publication and mention of the grant of the patent: **24.06.2026**
(21) Application number: 23768963.3
(22) Date of filing: 08.09.2023
(51) Int. Cl.: B41F 15/42, B41F 16/00, B41M 5/025, H05K 1/09, H05K 3/12, H05K 3/20

(54) **METHOD AND DEVICE FOR PRINTING A SUBSTANCE ON A TARGET SURFACE OF A TARGET**
VERFAHREN UND VORRICHTUNG ZUM BEDRUCKEN EINER ZIELFLÄCHE EINES ZIELS
PROCÉDÉ ET DISPOSITIF POUR IMPRIMER UNE SUBSTANCE SUR UNE SURFACE CIBLE D'UNE CIBLE

(30) Priority: 08.09.2022 EP 22194620
(43) Date of publication of application: 16.07.2025
(73) Proprietor: Nederlandse Organisatie voor toegepast- natuurwetenschappelijk onderzoek TNO, 2595 DA 's-Gravenhage (NL)
(72) Inventor: HENDRIKS, Rob Jacob, 2595 DA 's-Gravenhage (NL)
(74) Representative: V.O.
(86) International application number: PCT/NL2023/050460
(87) International publication number: WO 2024/054114

(56) References cited:
- US-A1- 2005 009 327
- US-A1- 2014 199 473
- US-A1- 2022 119 659

## Description

The present application pertains to a device for printing a substance on a target surface of a target.

The present application further pertains to a method for printing a substance on a target surface of a target.

International patent application WO2021230746 discloses a transfer method to transfer a substance formed by a viscous functional material onto a receiving substrate, where the deposited substance is subsequently cured or dried. The cured or dried substance transferred to the target may serve as an electrical insulator, an electrical conductor, a thermal insulator, a thermal conductor and the like.

The known method provides a plate with a plurality of individually addressable resistive heater elements. In use, the substance is heated with the resistive heater elements to vaporize an interface layer of a specimen of the substance at the side of the plate in order to induce a vapor pressure between the substance and the plate. The vapor pressure exerts a force on the substance that serves to eject the remaining, non-vaporized, portion of the substance away from the plate in order to cause its transfer from the plate to a target surface.

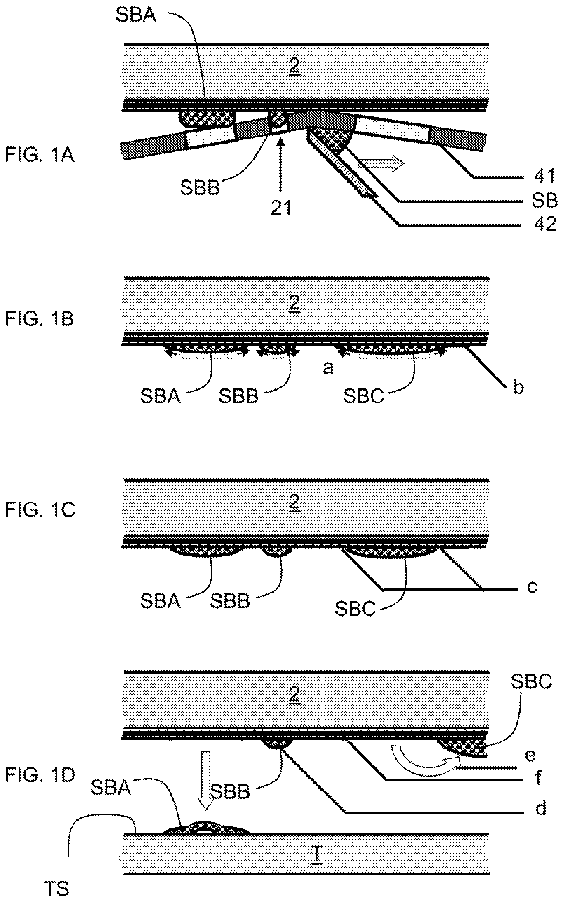

It was found by the inventor that occasionally transfer of the heated substance does not occur. In FIG. 1A to 1D, the inventor identified various underlying causes.

FIG. 1A shows how a screen print device 41, 42 is used to deposit specimen SBA, SBB of a substance SB at a first side 21 of the plate 2.

FIG. 1B and FIG. 1C show the plate 2 carrying the specimen SBA, SBB, SBC at two subsequent points in time after completion of this deposition process.

FIG. 1D shows a step wherein the specimen SBA, SBB, SBC on the plate are to be transferred to the target T.

As a result of the step shown in FIG. 1A, the specimen SBA, SBB, SBC are originally deposited on the plate 2 conformal to the openings in the screen 41.

As shown in the situation in FIG. 1B, due to capillary forces, the substance of the specimen SBA, SBB, SBC tends to spread out (a) between the surface and the stencil or screen, causing an underflow (b).

At a subsequent point in time, as shown in FIG. 1C, the substance spread out over the surface tends to dry (c).

As a result, in the operation shown in FIG. 1D the following phenomena may occur. Due to evaporation occurring in specimen SBB the shear forces prevent (d) a transfer thereof. Specimen SBC is partly released from the plate 2, but is withheld at one side, as a result of which the substance therein flips over (e) and remains at the plate. Also dried residue (e) may remain at the plate.

Unless the plate is cleaned before further use the dried residues remaining on the plate lead to alignment problems and sometimes prevents transfer altogether. The second cause of not transferring is mainly related to the material properties and geometry of the ink. If the viscosity, elastic modulus and aspect ratio are too low, then there is a high chance the ink is not transferred due to film oscillation.

As a further background the following patent publications are referred to:
US 2022/119659 discloses an indirect printing process in which a release surface of an intermediate transfer member (ITM) is pre-treated (e.g., coated) with an aqueous formulation before deposition of an ink image thereto. An ink-image residue (e.g., together with a dried treatment film layer) is transferred onto a printing substrate by pressured contact between the ITM and the printing substrate.

US 2005/009327 discloses an apparatus and method for formation of a wiring pattern on a substrate, and electronic devices and producing methods thereof. By utilizing energy fed from an energy feeder, the viscosity of the wiring material when the material is fed from the material feeder to the transfer plate is made different from that of the wiring material when the material is transferred from the transfer plate to the substrate.

US 2014/199473 discloses an apparatus for providing a patterned structure. The apparatus may comprise one or more of a heat source, a photon radiation source and a micro-wave source as the curing facility for curing a precursor for an electrically conductive material.

### SUMMARY

It is a first object of the present disclosure to provide an improved device for printing a substance on a target surface of a target that mitigates one or more of the above-mentioned shortcomings.

It is a second object of the present disclosure to provide an improved method for printing a substance on a target surface of a target that mitigates one or more of the above-mentioned shortcomings.

In accordance with the first object, an improved printing device for printing a substance on a target surface of a target is provided that is defined as follows. The improved printing device comprises a carrier having at a first main side a hydrophobic coating for carrying a specimen of the substance to be printed. Therewith the specimen rests with a contact surface on the hydrophobic coating. The hydrophobic coating has a relatively low surface energy, e.g. at most 50 mJ/m², or in some example at most 30 mJ/cm². Therewith the specimen of substance to be deposited assume a relatively high contact angle on the hydrophobic surface. A contact angle of about 90° is in many cases favorable, as in that case the specimen of substance tends to maintain the shape on the hydrophobic surface with which it was deposited thereon in a preparatory step. Nevertheless a higher contact angle may be favorable if it is intended to print the specimen as droplets on the target surface.

The printing device also comprises a heater facility to locally heat the specimen at its contact surface to vaporize a portion of the specimen at the side of its contact surface and inducing a vapor pressure that causes a transfer of a remainder of said specimen towards the target surface.

Due to the hydrophobic nature of the coating at the first main side of the carrier, the specimen of the substance does not tend to flow out and instead assumes a relative high contact angle with the carrier surface. Therewith shear forces due to evaporation of liquid components in the specimen in the time interval between the deposition on the carrier and the point in time of transfer to the target is mitigated.

In addition, as a result of the large contact-angle, the specimen have a high aspect ratio (thickness divided by diameter). This reduces the amplitude of the oscillating film (higher stiffness) during transfer, which reduces the risk of the ink retouching the heater plate. It also increases the chance of the ink to land in a convex shape.

Smaller features can be printed because of the limited spreading behavior on the hydrophobic coating.

Another advantage is that releasing the ink from a stencil onto a non-stick hydrophobic coating will work better because of the temperature gradient (and therewith also the viscosity gradient) is quite large over the thickness of the film. The shear forces between the ink and the stencil will be lower due to the lower viscosity, while the adhesion to the cold hydrophobic coating will increase due the to a higher viscosity. Especially for high aspect ratio openings in the stencil, where there is a relatively higher contact area with the stencil, it is easier to fully release the ink onto the heater plate.

The hydrophobic coating preferably is relative thin so that its thermal resistance is low, e.g. in a range of about 0.001 micron to about 10 micron. Suitable materials for the hydrophobic coating are ceramic materials like Si3N4 or Al2O3.

In operation the heater facility rapidly heats the substance at a side facing the hydrophobic surface. Therewith an interface layer of the substance at the side of the plate is vaporized. The vapor induces a vapor pressure between the substance and the plate. The vapor pressure exerts a force on the remaining substance that causes its transfer from the plate to a target surface.

In an embodiment the heater facility comprises a resistive heater layer that is arranged between the carrier and the hydrophobic coating. This embodiment is advantageous in that the heater facility requires only a minimum of space and can be easily controlled.

In another embodiment the heater facility is provided as a pulsed photon radiation source, such as a laser or a flash lamp, at a second main side of the carrier opposite the first main side. In operation the pulsed photon radiation source generates a pulsed beam of light that is transmitted through the carrier and the hydrophobic coating and is absorbed in the contact surface of the specimen of the substance to be printed. As an alternative a light-absorbing layer is provided between the transparent carrier and the hydrophobic coating. This alternative is more comparable to the embodiment comprising the resistive heater layer, the substance is indirectly heated through heat conduction via the hydrophobic coating.

In some embodiments the printing device further provides a cooling facility for forcedly cooling the carrier when it is not operational to transfer the substance. In an embodiment the support unit comprises a plurality of support elements that support the carrier at the second main side and that define cooling channels for conducting a cooling liquid, such as water. Therewith the carrier can be rapidly cooled down, or maintained at a low temperature. It can be favorable to maintain the carrier at a low temperature until the point in time that the substance is to be transferred so as to keep the viscosity of the substance at a high value. In some examples of the latter embodiment the support elements further define an evacuation groove facing the second main side of the carrier. An evacuation channel is enclosed by the walls of the evacuation groove and the surface of the carrier supported by the support unit. An excellent thermal contact between the support elements and the carrier is achieved when the evacuation channel is evacuated with a vacuum pump. Such a temperature controlled vacuum chuck for the carrier optimizes control over the print quality and repeatability. For example, when an ink layer that has an initial temperature of about 20∘C is printed onto a cooled carrier having as substantially lower temperature, the viscosity significantly increases. Simulations and experiments show that higher viscosities help to decrease the amplitude of the oscillating film of substance when being transferred, which reduces the chance of the substance to retouch the carrier subsequent to its ejection from the carrier surface. Because the film thickness is usually in the order of 100 microns or thinner, the substance quickly (< 1 second) obtains the relatively low temperature of the carrier. This means that it's only necessary to have temperature control over the support unit and the carrier supported therewith, and not the entire system. So deposition of the substance on the carrier by stencil/screen printing can be done at room temperature for example, which makes the printer system less expensive and less complicated. Although a metal stencil has a relatively high thermal conductivity, when using a print gap the total contact time between the warm stencil and the cold plate is short. Therefore the amount of heat transferred from the stencil to the carrier is limited. When printing specimen with a high aspect ratio, it is even particularly advantageous when the temperature of the stencil or mask is higher than that of the carrier. On the one hand, due to the relatively high temperature of the mask the specimen of substance can be released therefrom with a relatively low shear as its interface with the mask has a relatively low viscosity. On the other hand, the interface of specimen of substance in contact with the cold surface of the hydrophobic coating has an increased viscosity as a result of which the adhesion of the specimen on the hydrophobic surface increases. The higher the ratio between the area of the interface with the mask to the area of the interface with the surface of the hydrophobic coating the more advantageous this effect is.

Importantly, in operation the substance to be transferred is heated up at its interface with the hydrophobic surface up to hundreds of degrees Celsius in the order of microseconds. Therewith the remainder of the substance is already ejected by the vapor pressure, before it can be heated. For low thermally conductive substances (<1 W/mK) the thermal penetration depth is typically below 2 µm. This means that the majority of the film thickness stays cold and therefore will remain highly viscous and more stiff on average. This improves the printability of lower viscous fluids (< 10 Pa*s at 20C) and extends the aspect ratio and films widths that can be printed.

When cooling down the heater plate, measures are preferably taken to prevent condensation. In case of condensation the entire surface of the carrier would be covered with small water droplets. When rapidly heating, all these droplets would be transferred alongside the ink film. Hence it's important to stay above the dew point when the carrier is cooled down. This can easily be achieved by blowing dry air or nitrogen over the surface. If the relative humidity is for example 25% and the air temperature is 20C, then the carrier can be cooled down to 0C without any condensation. As such the lower humidity would increase the drying speed and increase the chance of drying the edges. However, the lower temperature of the carrier counterbalances this effect. In an embodiment the printing device comprises a controller for controlling environmental conditions such as temperature and ambient gas composition. Therewith the environmental conditions to be sufficient to avoid condensation while minimizing evaporation of substance before its transfer to the target.

In some embodiments one or more of the support elements have mounted therein a thermal sensor. Therewith the temperature of the carrier can be accurately determined, in particular if a good thermal contact is achieved by evacuating the evacuation channel.

In examples of embodiments wherein the heater facility comprises a resistive heater layer the carrier comprises at a second main side thereof, opposite the first main side, a plurality of electric contact elements of the resistive heater layer. The printing device may further comprise a support unit for supporting the carrier provided with spring loaded electric contact pins. When the support unit supports the carrier at the second main side the spring loaded electric contact pins cooperate with respective ones of the electric contact elements. In case the support unit comprises support elements as described above, these can be arranged between the spring loaded electric contact pins. In an example thereof a tip of the spring loaded electric contact pins is movable at least in a range between a level defined by a supporting surface of the support elements to above said supporting surface.

In some embodiments the printing device is configured to maintain the carrier at a predetermined temperature before the step of causing a transfer, by a combination of cooling with the support unit and selectively heating with the resistive heater layer. By selectively heating the carrier with the resistive heater layer spatial variations in the temperature (if any) can be rapidly minimized. In another embodiment a separate temperature control layer with resistive heaters (for example on a PCB) is used to equalize the temperature over the entire printing plate. For example, the separate temperature control layer is controlled with a proper temperature control system that provides for a homogeneous temperature based on input from temperature sensors distributed over the separate temperature control layer.

In an embodiment the printing device further comprises a screen printing unit or a stencil printing unit to deposit the substance on the hydrophobic coating. In particular for high aspect ratio structures it is advantageous when the components of the printing unit are also provided with a hydrophobic coating, so that the substance to be printed is easily transferred from the stencil or screen to the surface of the hydrophobic coating.

In accordance with the second object an improved method for printing a substance on a target surface of a target is provided.

According to the improved method a carrier is provided at a first main side with a hydrophobic coating.

Specimen of the substance to be printed is deposited on the hydrophobic coating, so that the specimen rests with a contact surface on the hydrophobic coating
Subsequently the specimen is heated at its contact surface to vaporize a portion of the specimen at the side of its contact surface. Therewith a vapor pressure is induced that causes a transfer of a remainder of the specimen towards the target surface.

Heating is performed at a high speed, so that only an interface layer of the substance is evaporated and the remainder is transferred by the vapor pressure. For example, once the substance is fully cooled down, a heat flux of 50 - 250 kW/cm2 and fluence of around 0.2 - 2 J/cm2 is used to evaporate a thin layer, e.g. a few micron of the liquid at the interface. This leads to pressure buildup and causes the remainder, e.g. having a thickness of tens of microns or more of the film of substance to transfer.

In an embodiment of the improved method according the step of providing the carrier with a hydrophobic layer is preceded by a step of providing a resistive heater layer at the first main side of the carrier and locally heating is performed with said resistive heater layer arranged between the carrier and the hydrophobic coating.

Various options are available for providing the carrier with the hydrophobic or oleophobic coating. Examples are atomic layer deposition, sputtering, chemical vapor deposition, evaporation. A high thermal conduction by the hydrophobic coating is achieved when the latter is relatively thin, e.g. less than a few micron. A small value of the thickness of the hydrophobic coating also contributes to its stability under the rapid temperature variations occurring in use. Atomic layer deposition is in particular suitable to obtain extremely thin coatings. For example Al2O3 coatings may be applied with this process.

In embodiments of the improved method the substance to be printed is deposited on the hydrophobic coating by stencil printing or screen printing.

In embodiments of the improved method the carrier with the hydrophobic coating is at least locally maintained at a temperature lower than an environment temperature at least from the moment of depositing the substance thereon until the substance is to be transferred. This minimizes evaporation and increases the viscosity of the substance.

### BRIEF DESCRIPTION OF THE DRAWINGS

These and other aspects are described in more detail with reference to the drawing. Therein:
FIG. 1A to 1D illustrate various phenomena that may hamper a process of thermally induced transfer of a substance to a target surface;
FIG. 2 schematically shows an embodiment of an improved printing device as disclosed herein;
FIG. 3 shows in more detail a further embodiment of the improved printing device;
FIG. 4A to 4D illustrates steps of an embodiment of an improved printing method as disclosed herein;
FIG. 5 shows results of a simulation of the improved printing device;
FIG. 6A shows a relationship between a temperature and a viscosity of a typical substance to be transferred with an embodiment of the improved printing device or the improved printing method;
FIG. 6B shows estimated oscillation amplitudes for specimen of a substance during transfer, dependent on their viscosity.

### DETAILED DESCRIPTION OF EMBODIMENTS

In the figures like reference symbols indicate like elements unless otherwise indicated.

In the following detailed description numerous specific details are set forth in order to provide a thorough understanding of the present invention. However, it will be understood by one skilled in the art that the present invention may be practiced without these specific details. In other instances, well known methods, procedures, and components have not been described in detail so as not to obscure aspects of the present invention.

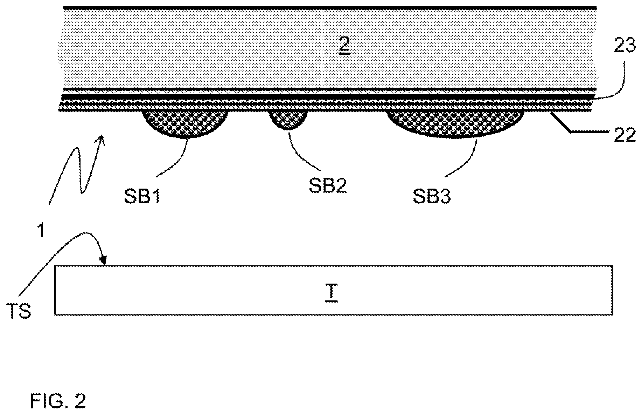

FIG. 2 schematically shows an printing device 1 for printing a substance on a target surface TS of a target T. The target T is for example a component to be manufactured, and the substance can have predetermined physical features, such as a specific electric conductivity and a specific thermal conductivity. For example, the substance can be an electrically insulating and thermally insulating material, an electrically insulating and thermally conductive material, an electrically conductive and thermally insulating material, and an electrically conductive and thermally conductive material. The substances, commonly also denoted as inks or pastes for example comprise nanoparticle or micronparticles or a mix thereof suspended in a (high boiling point) solvent. Also epoxy based materials, such as adhesives or conductive adhesives with silver micron particles are used. Alternatively or additionally the substance may comprise one or more of a positive or negative photoresist, a polymer solution, a molten polymer, a monomer or a silicone based material. For the purpose of the present invention it suffices that the substance comprises a component that can be evaporated at a relatively modest temperature, i.e. not higher than a few hundred degrees C.

As shown in FIG. 2, the printing device 1 comprises a carrier 2, for example a silicon wafer that at a first main side 21 is configured to carry specimen SB1, SB2, SB3 of the substance to be printed.

As further shown in FIG. 2, the printing device 1 further comprises a heater facility 23. In operation the heater facility 23 rapidly heats the specimen at its contact surface resting at the first main side 21 of the carrier 2. As a result thereof a portion of the specimen at the side of its contact surface vaporizes and therewith induces a vapor pressure that causes a transfer of a remainder of said specimen towards the target surface. In the example shown in FIG. 2, the heater facility 23 is a resistive heater layer, e.g. formed by molybdenum or tungsten.

As shown in FIG. 2, the carrier 2 is provided at a first main side 21 with a hydrophobic coating 22 for carrying the specimen SB1, SB2, SB3 of the substance to be printed. As a result of the hydrophobic coating 22, the specimen SB1, SB2, SB3 carried by the carrier 2 have a contact-angle that is higher than would be the case in the absence of the hydrophobic coating 22. Therewith the hydrophobic coating 22 mitigates a flowing out of the substance and therewith also a drying out of the specimen at their periphery. As an example, the hydrophobic coating has a surface energy of at most 50 mJ/m2. More preferably the hydrophobic coating has a surface energy of at most 30 mJ/m2.

In some cases it is also possible to use superhydrophobic or superoleophobic coatings. This is for example the case if it is desired to print the specimen of the substance as droplets. In case of highly viscous substances a forming of droplets can be avoided if the specimen SB1, SB2, SB3 of the substance are rapidly transferred to the target T subsequent to their deposition on the coating 22, for example with a stencil/screen printing process.

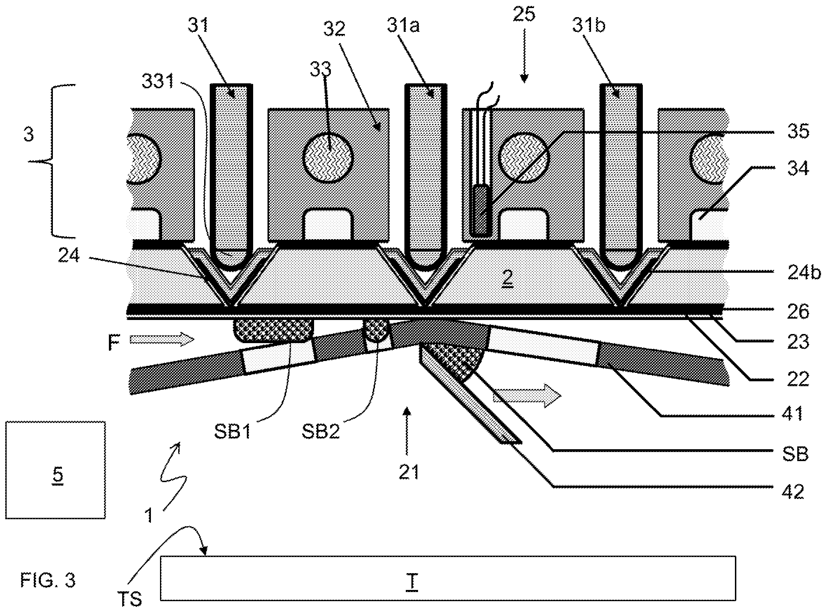

FIG. 3 shows an embodiment of the improved printing device 1 in more detail. Parts therein corresponding to those of FIG. 2 have the same reference number.

In the embodiment shown in FIG. 3, the support unit 3 comprises a plurality of support elements 32 for supporting the carrier 2 at the second main side 25. The support elements 32 define cooling channels 33 for conducting a cooling liquid. In operation the cooling liquid, e.g. water having a temperature slightly above 0C is pumped through the cooling channels 33.

FIG. 3 further shows that in this embodiment of the improved printing device the support elements 32 further define an evacuation groove 34 facing the second main side 25 of the carrier 2. As visible in FIG. 3, where the support unit 3 supports the carrier 2, an evacuation channel is enclosed by the walls of the evacuation groove 34 and the carrier. In order to improve the thermal contact between the cooled support elements 32 and the carrier 2 the evacuation channels so formed are evacuated with a vacuum pump (not shown).

One or more of the support elements 32 of the printing device of FIG. 3 have mounted therein a temperature sensor 35.

FIG. 3 further shows that the carrier 2 comprises at its second main side 25 a plurality of electric contact elements 24, ..., 24b,... of the resistive heater layer 23. The support unit 3 is provided with spring loaded electric contact pins 31, 31a, 31b,... to cooperate with respective ones of said electric contact elements 24, .., 24b, .... Therewith heating of the surface formed by the hydrophobic coating 22 can be controlled region wise or pixel wise, for selective transfer of specimen SB1, SB2 of the substance on the surface. A thermally and electrically insulating layer 26 is provided between the carrier 2 and the resistive heater layer 23. For example, in case the carrier is a silicon wafer, the thermally and electrically insulating layer 26 can be provided by oxidizing the surface of the wafer. In other examples a thermally and electrically insulating layer is absent.

In the embodiment shown in FIG. 3 the spring loaded electric contact pins 31, 31a, 31b are laterally arranged between the support elements 32. A tip 311 of the spring loaded electric contact pins 31, 31a, 31b is movable at least in a range between a level defined by a supporting surface of the support elements to above said supporting surface.

The printing device 1 of FIG. 3 comprises means (not shown) for inducing a dry air flow F, so as to avoid a condensation of moisture on the hydrophobic coating 22 or on the substance present thereon.

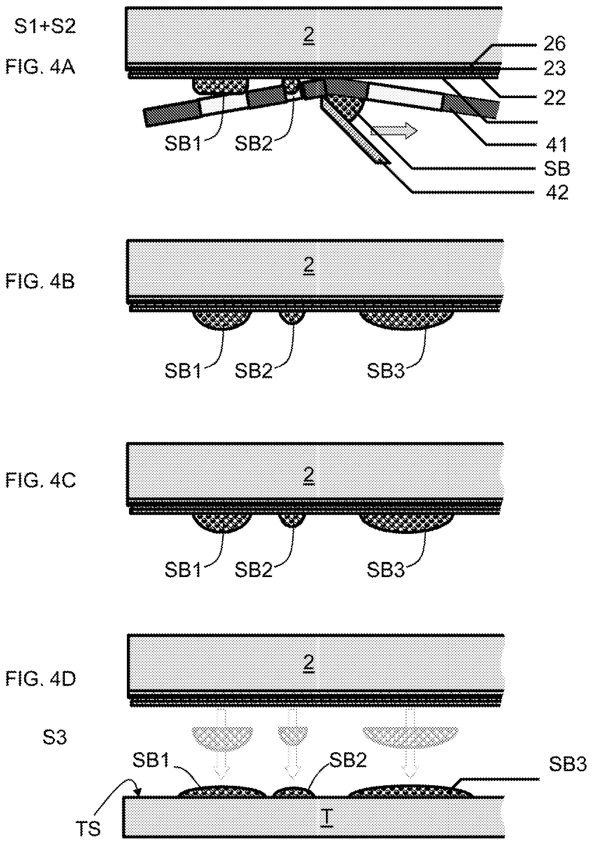

The printing device 1 has a controller 5 that is configured to control operational steps of the printing device as illustrated in FIG. 4A - 4D. For clarity therein the support unit (3 in FIG. 3) for supporting the carrier 2 is not shown therein. Also the contact elements (24, .., 24b, .... in FIG. 3) of the resistive heater layer 23 are not shown for clarity.

As shown in FIG. 4A in a step S1, a carrier 2 has been provided at a first main side 21 with a hydrophobic coating 22.

FIG. 4A further shows that specimen SB1, SB2, SB3 of the substance to be printed is deposited on the hydrophobic coating 22. As a result the specimen rests with a contact surface on the coating. The controller 5 controls the screen printing device 41, 42 to perform this step S2. Optionally the controller 5 may control a device (not shown) to induce a dry air flow F and/or control a device to provide cooling liquid to circulate through the cooling channels (33 in FIG. 3) and/or control a device to evacuate the evacuation channels formed in the evacuation grooves (34 in FIG. 3). Furthermore, the controller may receive input from the one or more temperature sensors (35 in FIG. 3). Based on input from the temperature sensors the controller is configured to maintain the carrier 2 at a predetermined temperature before the step of causing a transfer of substance. In an example the controller is configured to maintain a low temperature of the carrier by regulating a flow of cooling liquid. In some examples the controller selectively heats the carrier 2 with the resistive heater layer 23. In that case the controller may achieve with the cooling liquid that the temperature of the carrier 2 does not exceed a predetermined reference temperature and further control the heater layer 23 so as to locally heat locations that otherwise would be substantially below that reference temperature.

As shown in FIG. 4B, 4C at subsequent points in time after removing the print screen 41, the specimen SB1, SB2, SB3 of the substance remain within their corresponding deposition area. Due to the high contact angle with the surface formed by the hydrophobic coating effects of evaporation at their edges is mitigated. Evaporation is still further mitigated in the examples wherein the carrier 2 is cooled in this stage. Cooling also causes the viscosity of the substance to increase, which reduces any tendency of the substance of the substance to flow and therewith restricts shape changes of deposited specimen SB1, SB2, SB3.

In a subsequent step S3 shown in FIG. 4D, the controller (5 in FIG. 3) causes the heater facility, e.g. the resistive heater layer 23 or a pulsed photon radiation source, to locally heat the specimen SB1, SB2, SB3 at its contact surface to vaporize a portion of the specimen at the side of its contact surface with the hydrophobic layer 22. Therewith a vapor pressure that causes a transfer of a remainder of the specimen towards the target surface TS of the target T. As shown in FIG. 4D the transfer process taking place in this step S3 is improved as compared to the situation shown in FIG. 1D. This improvement is achieved with the hydrophobic coating 22 in the following ways. Firstly, it's more difficult for the liquid substance to dry on the edges, which prevents any unwanted shear forces. And secondly, due to the relatively high contact angle of the specimen with the surface of the hydrophobic coating the aspect ratio (thickness/lateral size) of the specimen is increased, which reduces the amplitude of oscillations of the specimen during transfer. This reduces the risk of the substance retouching the carrier. It also increases the chance of the ink to land in a convex shape, which contributes to a proper coverage of the specimen on the target surface TS. The reduction of oscillation amplitude is due to the fact that the higher aspect ratio of the specimen results in an increased stiffness. A further increase of stiffness, contributing to a reduction of an oscillation amplitude, is achieved in the embodiment wherein the carrier 2 is cooled until the point in time that the transfer step S3 is performed. Due to the fact that heating the specimen in step S3 is performed rapidly, the majority of the substance of the specimen is ejected from the hydrophobic surface 22 before it can be heated, so that it substantially maintains the low temperature which it obtained when in contact with the surface of the hydrophobic coating of the cooled carrier 2.

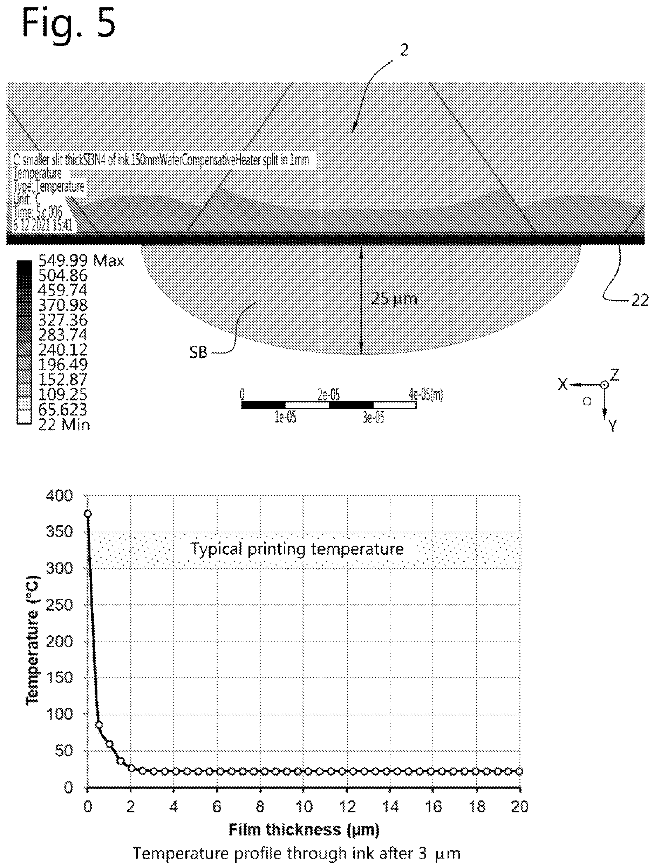

FIG. 5 illustrates results of a simulation. The upper part of FIG. 5 shows the specimen SB of substance on the surface of the hydrophobic coating 22 of the carrier 2 immediately before its transfer to the target. Therein the simulated heat flux to be generated with the heater facility is 150 kW/cm2. From this simulation it becomes apparent that it is sufficient to evaporate an interface layer of less than 2 µm of the low thermally conductive substance (0.4 W/mK) for transferring it from the surface of the hydrophobic layer 22 to the target. So for a 25 micron thick film of substance SB, the majority remains highly viscous during transfer. The transfer velocity is typically in the order of 5 - 30 m/s, which means that the substance only transfers for less than 200 µs (1 - 6 mm print gap). In this short time-interval the temperature of the substance, and therewith its viscosity hardly changes.

The lower part of FIG. 5 shows the temperature profile of the substance SB 3 microseconds after the start of generating the heat flux. The temperature profile confirms that an interface layer of the substance SB is heated to a temperature of about 300C, at which evaporation of the substance occurs for building a vapor pressure. The majority of the thickness, at a depth of 2 micron or more remains at the original temperature, for example room temperature (about 20C) or a lower temperature, when the carrier 2 is cooled in advance.

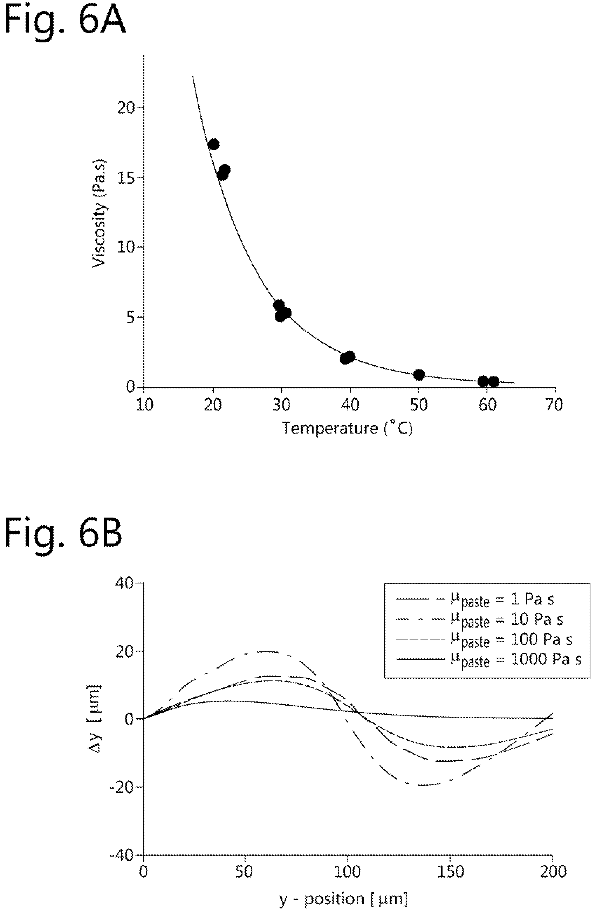

FIG. 6A illustrates a significant dependency between the viscosity and the temperature of a typical substance.

FIG. 6B shows oscillation occurring in a specimen of substance during its transfer from the carrier 2 to the surface TS of the target dependent on the viscosity of the substance. The horizontal axis indicates the center distance y from the specimen to the printing plate a lateral position y along the specimen. The vertical axis Δy indicates the amount with which distance y from the specimen to the printing plate deviates at the edge of the specimen due to oscillations occurring therein. When the value of Δy is positive, the pancake shaped specimen bends outwards (with respect to the plate), and when it's negative, it is curved in the other direction. The relationship is shown for four values of the viscosity: 1 Pa.s, 10 Pa.s, 100 Pa.s and 1000 Pa.s. As becomes apparent from FIG. 6B, increasing viscosity has the effect of reducing the oscillation amplitude. This can be achieved by cooling the carrier 2 until the point in time of transfer. As noted above, the hydrophobic coating 22 results in higher aspect ratio structures, which makes the film of substance more stiff and more curved. In addition the viscosity of the substance can be increased by cooling the carrier. The higher the curvature, aspect ratio and viscosity, the higher the chance the film will land in a convex shape and prevent bubble entrapment.

In the claims the word "comprising" does not exclude other elements or steps, and the indefinite article "a" or "an" does not exclude a plurality. A single component or other unit may fulfill the functions of several items recited in the claims. The mere fact that certain measures are recited in mutually different claims does not indicate that a combination of these measures cannot be used to advantage. Any reference signs in the claims should not be construed as limiting the scope.

## Claims

1. A printing device (1) for printing a substance on a target surface (TS) of a target (T), the printing device comprising a carrier (2) having at a first main side (21) a hydrophobic coating (22) for carrying a specimen (SB1, SB2, SB3) of the substance to be printed, said specimen resting with a contact surface on the coating,
the printing device further comprising a heater facility to locally heat the specimen at its contact surface to vaporize a portion of the specimen at the side of its contact surface, to therewith induce a vapor pressure that causes a transfer of a remainder of said specimen towards the target surface.

2. The printing device (1) according to claim 1, wherein the hydrophobic coating has a thickness in a range of about 0.001 micron to about 10 micron.

3. The printing device (1) according to claim 1 or 2, wherein the heater facility comprises a resistive heater layer (23) arranged between the carrier (2) and the hydrophobic coating (22).

4. The printing device (1) according to any of the preceding claims, further comprising a support unit (3) with a plurality of support elements (32) for supporting the carrier (2) at a second main side opposite the first main side, which support elements define cooling channels (33) for conducting a cooling liquid.

5. The printing device (1) according to claim 4, wherein the support elements (32) further define an evacuation groove (34) facing the second main side of the carrier, which evacuation groove when supporting the carrier form an evacuation channel configured to be evacuated with a vacuum pump.

6. The printing device (1) according to claim 4 or 5, wherein one or more of the support elements (32) have mounted therein a temperature sensor (35).

7. The printing device (1) according to claim 3, wherein the carrier (2) comprises at a second main side thereof, opposite the first main side, a plurality of electric contact elements (24, ..., 24b,...) of the resistive heater layer (23) and wherein the printing device further comprising a support unit (3) for supporting the carrier (2) at the second main side, which support unit (3) is provided with spring loaded electric contact pins (31, 31a, 31b,...) to cooperate with respective ones of said electric contact elements (24, .., 24b, ...).

8. The printing device (1) according to claim 7 in combination with one of claim 4,5 and 6, wherein the support elements (32) are arranged between the spring loaded electric contact pins (31, 31a, 31b), and wherein a tip (311) of the spring loaded electric contact pins (31, 31a, 31b) is movable at least in a range between a level defined by a supporting surface of the support elements to above said supporting surface.

9. The printing device according to claim 4, 5, 6 or 8, configured to maintain the carrier (2) at a predetermined temperature before the step of causing a transfer, by a combination of cooling with the support unit (3) and selectively heating with the resistive heater layer (23) or with a separate temperature control layer with resistive heaters to equalize the temperature over the entire printing plate controlled by a proper temperature control system.

10. The printing device (1) according to claim 1 or 2, wherein the heater facility comprises a pulsed light source arranged at a second main side of the carrier (2) opposite the first main side and that is configured to generate a pulsed beam of light to be transmitted through the carrier (2) and the hydrophobic coating (22) and to be absorbed in the contact surface of the specimen of the substance to be printed or in a radiation absorbing layer, optionally being the hydrophobic coating, at the first main side of the carrier.

11. The printing device (1) according to one or more of the preceding claims, further comprises a controller (5) for controlling environmental conditions such as temperature and ambient gas composition.

12. The printing device (1) according to one or more of the preceding claims, further comprising a screen printing unit (41, 42) or stencil printing unit to deposit the substance on the hydrophobic coating.

13. The printing device (1) according to claim 12, wherein the components (41, 42) of the printing unit also are provided with a hydrophobic coating.

14. A method of printing a substance on a target surface (TS) of a target (T), the method comprising:
providing (S1) a carrier (2) at a first main side (21) with a hydrophobic coating (22);
depositing (S2) specimen (SB1, SB2, SB3) of the substance to be printed on the hydrophobic coating, said specimen resting with a contact surface on the coating,
locally heating the specimen at its contact surface to vaporize a portion of the specimen at the side of its contact surface, therewith inducing a vapor pressure that causes a transfer (S3) of a remainder of said specimen towards the target surface.

15. The method according to claim 14, wherein the step of providing a carrier (2) is preceded by a step providing a resistive heater layer at the first main side (21) of the carrier (2) and wherein locally heating is performed with said resistive heater layer (23) arranged between the carrier (2) and the hydrophobic coating (22).

16. The method according to any of the claims 14 or 15, wherein the carrier (2) with the hydrophobic coating (22) is at least locally maintained at a temperature lower than an environment temperature at least from the moment of depositing the substance thereon until the substance is to be transferred.

## Patentansprüche

1. Druckvorrichtung (1) zum Drucken einer Substanz auf eine Zieloberfläche (TS) eines Ziels (T), wobei die Druckvorrichtung einen Träger (2) aufweist, der an einer ersten Hauptseite (21) eine hydrophobe Beschichtung (22) zum Tragen einer Probe (SB1, SB2, SB3) der zu druckenden Substanz aufweist, wobei die Probe mit einer Kontaktoberfläche auf der Beschichtung aufliegt,
wobei die Druckvorrichtung ferner eine Heizeinrichtung aufweist, um die Probe an ihrer Kontaktoberfläche lokal zu erwärmen, um einen Teil der Probe an der Seite ihrer Kontaktoberfläche zu verdampfen, um damit einen Dampfdruck zu induzieren, der eine Übertragung eines Rests der Probe in Richtung der Zieloberfläche bewirkt.

2. Druckvorrichtung (1) nach Anspruch 1, wobei die hydrophobe Beschichtung eine Dicke in einem Bereich von etwa 0,001 Mikrometer bis etwa 10 Mikrometer aufweist.

3. Druckvorrichtung (1) nach Anspruch 1 oder 2, wobei die Heizeinrichtung eine Widerstandsheizschicht (23) aufweist, die zwischen dem Träger (2) und der hydrophoben Beschichtung (22) angeordnet ist.

4. Druckvorrichtung (1) nach einem der vorhergehenden Ansprüche, die ferner eine Halterungseinheit (3) aufweist mit einer Vielzahl von Halterungselementen (32) zum Halten des Trägers (2) an einer der ersten Hauptseite gegenüberliegenden zweiten Hauptseite, wobei die Halterungselemente Kühlkanäle (33) zum Leiten einer Kühlflüssigkeit definieren.

5. Druckvorrichtung (1) nach Anspruch 4, wobei die Halterungselemente (32) ferner eine Evakuierungsnut (34) definieren, die der zweiten Hauptseite des Trägers zugewandt ist, wobei die Evakuierungsnut, wenn sie den Träger hält, einen Evakuierungskanal bildet, der konfiguriert ist, um mit einer Vakuumpumpe evakuiert zu werden.

6. Druckvorrichtung (1) nach Anspruch 4 oder 5, wobei in einem oder mehreren der Halterungselemente (32) ein Temperatursensor (35) angebracht ist.

7. Druckvorrichtung (1) nach Anspruch 3, wobei der Träger (2) an einer zweiten Hauptseite, die der ersten Hauptseite gegenüberliegt, eine Vielzahl von elektrischen Kontaktelementen (24, ... , 24b, ... ) der Widerstandsheizschicht (23) aufweist und wobei die Druckvorrichtung ferner eine Halterungseinheit (3) zum Halten des Trägers (2) an der zweiten Hauptseite aufweist, wobei die Halterungseinheit (3) mit federbelasteten elektrischen Kontaktstiften (31, 31a, 31b, ...) versehen ist, um mit den jeweiligen der elektrischen Kontaktelemente (24, ..., 24b, ...) zusammenzuwirken.

8. Druckvorrichtung (1) nach Anspruch 7 in Kombination mit einem der Ansprüche 4, 5 und 6, wobei die Halterungselemente (32) zwischen den federbelasteten elektrischen Kontaktstiften (31, 31a, 31b) angeordnet sind, und wobei eine Spitze (311) der federbelasteten elektrischen Kontaktstifte (31, 31a, 31b) zumindest in einem Bereich zwischen einem durch eine Halterungsoberfläche der Halterungselemente definierten Niveau bis oberhalb der besagten Halterungsoberfläche bewegbar ist.

9. Druckvorrichtung nach Anspruch 4, 5, 6 oder 8, die so konfiguriert ist, dass sie den Träger (2) vor dem Schritt des Bewirkens einer Übertragung auf einer vorbestimmten Temperatur hält, und zwar durch eine Kombination aus Kühlen mit der Halterungseinheit (3) und selektivem Erwärmen mit der Widerstandsheizschicht (23) oder mit einer separaten Temperatursteuerungsschicht mit Heizwiderständen, um die Temperatur über die gesamte Druckplatte auszugleichen, die von einem geeigneten Temperatursteuerungssystem gesteuert wird.

10. Druckvorrichtung (1) nach Anspruch 1 oder 2, wobei die Heizeinrichtung eine gepulste Lichtquelle aufweist, die an einer zweiten Hauptseite des Trägers (2) gegenüber der ersten Hauptseite angeordnet und so konfiguriert ist, dass sie einen gepulsten Lichtstrahl erzeugt, der durch den Träger (2) und die hydrophobe Beschichtung (22) übertragen und in der Kontaktoberfläche der Probe der zu druckenden Substanz oder in einer strahlungsabsorbierenden Schicht, bei der es sich gegebenenfalls um die hydrophobe Beschichtung handelt, an der ersten Hauptseite des Trägers absorbiert wird.

11. Druckvorrichtung (1) nach einem oder mehreren der vorhergehenden Ansprüche, die ferner eine Steuerung (5) zur Steuerung von Umgebungsbedingungen wie Temperatur und Umgebungsgaszusammensetzung umfasst.

12. Druckvorrichtung (1) nach einem oder mehreren der vorangehenden Ansprüche, die ferner eine Siebdruckeinheit (41, 42) oder eine Schablonendruckeinheit zum Aufbringen der Substanz auf die hydrophobe Beschichtung aufweist.

13. Druckvorrichtung (1) nach Anspruch 12, wobei die Komponenten (41, 42) der Druckeinheit ebenfalls mit einer hydrophoben Beschichtung versehen sind.

14. Verfahren zum Drucken einer Substanz auf eine Zieloberfläche (TS) eines Ziels (T), wobei das Verfahren Folgendes umfasst:
Bereitstellen (S1) eines Trägers (2) an einer ersten Hauptseite (21) mit einer hydrophoben Beschichtung (22);
Aufbringen (S2) einer Probe (SB1, SB2, SB3) der zu bedruckenden Substanz auf der hydrophoben Beschichtung, wobei die Probe mit einer Kontaktoberfläche auf der Beschichtung aufliegt,
lokales Erwärmen der Probe an ihrer Kontaktoberfläche, um einen Teil der Probe an der Seite ihrer Kontaktoberfläche zu verdampfen, wodurch ein Dampfdruck erzeugt wird, der eine Übertragung (S3) eines Rests der Probe in Richtung der Zieloberfläche bewirkt.

15. Verfahren nach Anspruch 14, wobei dem Schritt des Bereitstellens eines Trägers (2) ein Schritt des Bereitstellens einer Widerstandsheizschicht an der ersten Hauptseite (21) des Trägers (2) vorausgeht und wobei die lokale Erwärmung mit der besagten Widerstandsheizschicht (23) durchgeführt wird, die zwischen dem Träger (2) und der hydrophoben Beschichtung (22) angeordnet ist.

16. Verfahren nach einem der Ansprüche 14 oder 15, bei dem der Träger (2) mit der hydrophoben Beschichtung (22) zumindest lokal auf einer Temperatur gehalten wird, die niedriger ist als die Umgebungstemperatur, und zwar zumindest ab dem Zeitpunkt, zu dem die Substanz darauf aufgebracht wird, bis die Substanz übertragen werden soll.

## Revendications

1. Dispositif d'impression (1) pour imprimer une substance sur une surface cible (TS) d'une cible (T), le dispositif d'impression comprenant un support (2) doté d'un revêtement hydrophobe (22) sur un premier côté principal (21) pour porter un échantillon (SB1, SB2, SB3) de la substance à imprimer, ledit échantillon reposant sur le revêtement via une surface de contact,
le dispositif d'impression comprenant en outre une installation chauffante pour chauffer localement l'échantillon au niveau de sa surface de contact afin de vaporiser une partie de l'échantillon du côté de sa surface de contact, ce qui permet d'induire une pression de vapeur qui provoque un transfert d'un reste dudit échantillon vers la surface cible.

2. Dispositif d'impression (1) selon la revendication 1, dans lequel le revêtement hydrophobe a une épaisseur dans une plage allant d'environ 0,001 micron à environ 10 microns.

3. Dispositif d'impression (1) selon la revendication 1 ou 2, dans lequel l'installation chauffante comprend une couche de résistance chauffante (23) agencée entre le support (2) et le revêtement hydrophobe (22).

4. Dispositif d'impression (1) selon l'une des revendications précédentes, comprenant en outre une unité de soutien (3) dotée d'une pluralité d'éléments de soutien (32) pour soutenir le support (2) sur un deuxième côté principal opposé au premier côté principal, lesquels éléments de soutien définissant des canaux de refroidissement (33) pour acheminer un liquide de refroidissement.

5. Dispositif d'impression (1) selon la revendication 4, dans lequel les éléments de soutien (32) définissent en outre une rainure d'évacuation (34) faisant face au deuxième côté principal du support, laquelle rainure d'évacuation, en soutenant le support, formant un canal d'évacuation configuré pour une évacuation par une pompe à vide.

6. Dispositif d'impression (1) selon la revendication 4 ou 5, dans lequel un capteur de température (35) est monté dans un ou plusieurs des éléments de soutien (32).

7. Dispositif d'impression (1) selon la revendication 3, dans lequel le support (2) comprend une pluralité d'éléments de contact électrique (24, ..., 24b, ...) de la couche de résistance chauffante (23) sur un deuxième côté principal de celui-ci opposé au premier côté principal, et dans lequel le dispositif d'impression comprend en outre une unité de soutien (3) pour soutenir le support (2) sur le deuxième côté principal, laquelle unité de soutien (3) est pourvue de broches de contact électrique à ressort (31, 31a, 31b, ...) pour coopérer avec des éléments respectifs desdits éléments de contact électrique (24, ..., 24b, ...).

8. Dispositif d'impression (1) selon la revendication 7 en combinaison avec l'une des revendications 4, 5 et 6, dans lequel les éléments de soutien (32) sont agencés entre les broches de contact électrique à ressort (31, 31a, 31b), et dans lequel une pointe (311) des broches de contact électrique à ressort (31, 31a, 31b) est mobile au moins dans une plage entre un niveau défini par une surface de soutien des éléments de soutien et au-dessus de ladite surface de soutien.

9. Dispositif d'impression selon la revendication 4, 5, 6 ou 8, configuré pour maintenir le support (2) à une température prédéterminée avant l'étape provoquant un transfert, par une combinaison d'un refroidissement par l'unité de soutien (3) et d'un chauffage sélectif par la couche de résistance chauffante (23), ou par une couche de régulation de température séparée dotée de résistances chauffantes pour uniformiser la température sur toute la plaque d'impression régulée par un système de régulation de température approprié.

10. Dispositif d'impression (1) selon la revendication 1 ou 2, dans lequel l'installation chauffante comprend une source de lumière pulsée agencée sur un deuxième côté principal du support (2) opposé au premier côté principal, et qui est configurée pour générer un faisceau de lumière pulsé à transmettre via le support (2) et le revêtement hydrophobe (22) et devant être absorbé dans la surface de contact de l'échantillon de la substance à imprimer ou dans une couche absorbant le rayonnement, qui est facultativement le revêtement hydrophobe, sur le premier côté principal du support.

11. Dispositif d'impression (1) selon une ou plusieurs des revendications précédentes, comprenant en outre un contrôleur (5) pour réguler des conditions environnementales telles que la température et la composition du gaz ambiant.

12. Dispositif d'impression (1) selon une ou plusieurs des revendications précédentes, comprenant en outre une unité d'impression au cadre (41, 42) ou une unité d'impression au pochoir pour déposer la substance sur le revêtement hydrophobe.

13. Dispositif d'impression (1) selon la revendication 12, dans lequel les composants (41, 42) de l'unité unité d'impression sont également pourvus d'un revêtement hydrophobe.

14. Procédé d'impression d'une substance sur une surface cible (TS) d'une cible (T), le procédé comprenant les étapes suivantes :
fournir (S1) un support (2) doté d'un revêtement hydrophobe (22) sur un premier côté principal (21) ;
déposer (S2) un échantillon (SB1, SB2, SB3) de la substance à imprimer sur le revêtement hydrophobe, ledit échantillon reposant sur le revêtement via une surface de contact,
chauffer localement l'échantillon au niveau de sa surface de contact afin de vaporiser une partie de l'échantillon du côté de sa surface de contact, ce qui permet d'induire une pression de vapeur qui provoque un transfert (S3) d'un reste dudit échantillon vers la surface cible.

15. Procédé selon la revendication 14, dans lequel l'étape fournissant un support (2) est précédée d'une étape fournissant une couche de résistance chauffante sur le premier côté principal (21) du support (2), et dans lequel le chauffage local est réalisé via ladite couche de résistance chauffante (23) agencée entre le support (2) et le revêtement hydrophobe (22).

16. Procédé selon l'une des revendications 14 ou 15, dans lequel le support (2) doté du revêtement hydrophobe (22) est maintenu au moins localement à une température inférieure à une température environnante au moins à partir du moment où la substance y est déposée jusqu'au moment où la substance doit être transférée.
